# EUROPEAN PATENT APPLICATION

(11) **EP 1 225 476 A1**
(43) Date of publication of application: **24.07.2002**
(21) Application number: 01310212.4
(22) Date of filing: 06.12.2001
(51) Int. Cl.: G03F 7/00, G11B 7/26, G03F 7/027, G03F 7/031, G03F 7/032, G03F 7/039, G03F 7/022, G03F 7/023

(54) **Positive photoresist for the production of an information recording medium, manufacturing method of the information recording medium and the information recording medium**

(30) Priority: 13.12.2000 JP 2000378513
(71) Applicant: VICTOR COMPANY OF JAPAN, LTD., Yokohama-Shi, Kanagawa-Ken (JP)
(72) Inventor: Ohgo, Takashi, Yokohama-shi, Kanagawa-ken (JP)
(74) Representative: Butcher, Ian James

(57) **Abstract**

An information recording medium in higher quality of which pit deformation is suppressed by setting film strength of a photoresist within a predetermined range is provided. A positive photoresist utilized for manufacturing the information recording medium, which is recorded with an information signal formed as a pit or a groove on a disc, is constituted such that a modulus of compression elasticity of a solid component of the photoresist after removing a solvent component is set within a range of 8.0 × 10⁻³ to 5.0 × 10⁻¹ MPa at 100 °C.

## Description

### BACKGROUND OF THE INVENTION

### Field of the Invention:

The present invention relates to positive photoresist for an information recording medium, and a manufacturing method of an information recording medium by making use of the positive photoresist and the information recording medium.

### Description of the Related Art:

Recently, in the field of information recording, studies related to an optical information recording method have been advanced in various places. The optical information recording method has various advantages such that recording and reproducing can be performed by being out of contact with an information recording medium, higher recording density than a magnetic recording by more than one figure can be realized and the method can cope with any memory configurations such as a read only type, a recordable type and a rewritable type. Further, the optical information recording method is used for wide range of applications covering an industrial use over to an individual use as a method of enabling to realize a less expensive file in large capacity. Particularly, a digital audio disc and an optical video disc, which is an optical disc as an information recording medium coping with a read only type memory configuration, has been popularized.

The digital audio disc mentioned above is formed with a reflection layer composed of a metal thin film such as an aluminum film on an optical disc substrate, which is a transparent substrate being formed with a rugged pattern such as a pit exhibiting an information signal and a groove. Further, a protective film is formed over the reflection layer in order to protect the reflection layer from moisture, oxygen or dust in the air. In a case of reproducing an information recorded on such an optical disc, a reproducing light such as a laser beam is irradiated on the rugged pattern mentioned above from the side of optical disc substrate and the information is detected by difference of reflectivity between an incident light and a reflected light.

In the above-mentioned information recording medium, hereinafter referred to as an optical disc, higher packing density and higher recording capacity has been required for such an optical disc. In order to cope with such the requirement, enlarging a numerical aperture (hereinafter referred to as NA) of an objective lens for irradiating a reproducing light beam from an optical pickup and reducing a spot diameter of the reproducing light beam have been proposed. Recently, by setting an NA of objective lens to the order of 0.60, for example, in comparison with a conventional digital audio disc of which an NA of objective lens was 0.45, an optical video disc such as a digital video disc having six to eight times larger recording capacity than that of a conventional digital audio disc has been realized and has been under a concentrated attention. Further, in such an optical video disc, a pit array having a minimum pit length of 0.4 µm and a track pitch of 0.74 µm is formed spirally and an information capacity of 4.7 GB is provided on a single side of optical disc having a diameter of 12 cm.

This kind of optical disc is manufactured through manufacturing processes, which are divided into two major processes such as a mastering process and a replication process. The mastering process is a process of completing a mold, which is necessary for an optical disc to replicate a pattern exhibiting information on a substrate of the optical disc, and the replicating process is another process of completing the optical disc.

Further, in the mastering process, photoresist as a photosensitive resin is coated on a glass substrate and a pattern exhibiting information is formed on the glass substrate by exposing the photoresist by irradiating a laser beam on the photoresist. The pattern on the glass substrate is transferred to a metal surface by using a method such as the electrotyping method, and then a stamper is formed by using the metal surface as a master.

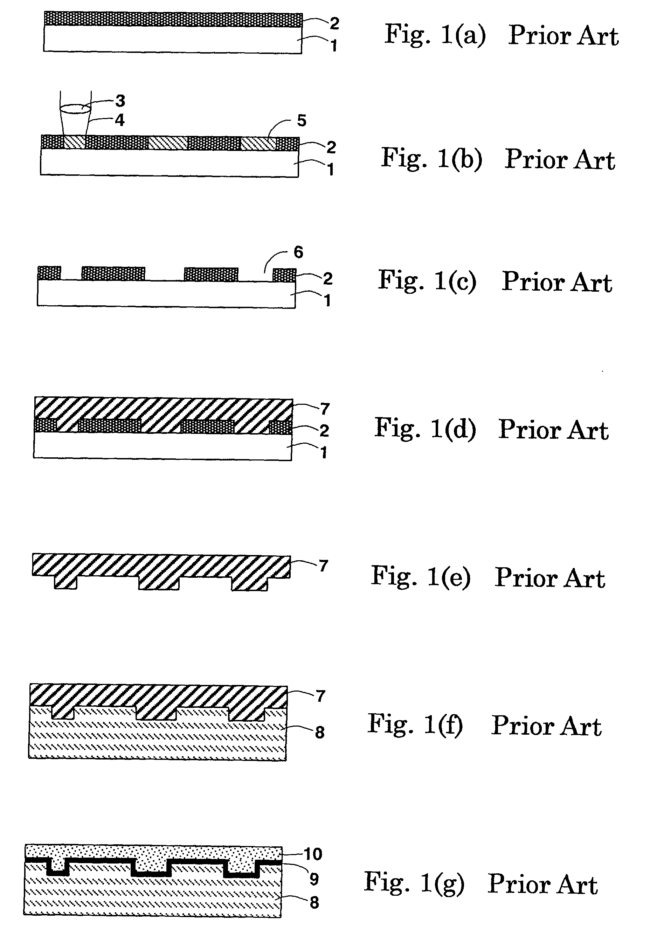

Figs. 1(a) through 1(g) are a process chart showing each step of a manufacturing process of an information recording medium in general. In Fig. 1(a), coating ultraviolet photosensitive photoresist on one surface of a glass substrate 1 having a thickness of some mm, for example, by the spin coat method forms a film 2 composed of the photoresist having a film thickness of approximately 0.1 µm. In Fig. 1(b), irradiating a laser beam 4 on the film 2 through a lens 3 and switching on and off the laser beam 4 in response to a signal exhibiting information so as to expose the film 2 of the photoresist spot by spot forms a latent image 5 having a pit as a pattern or a group of microscopic patterns exhibiting the information while rotating the glass substrate 1. In Fig. 1(c), developing the film 2 of the photoresist completes a microscopic pattern 6. In Figs. 1(d) and 1(e), forming a conductive film on the surface of the microscopic pattern 6 by sputtering a metal such as nickel and transferring the pattern by plating nickel over the conductive film obtains a stamper 7.

By using the stamper 7 as an injection mold, resin such as a polycarbonate resin 8 is injected into the stamper 7 as shown in Fig. 1(f), wherein the polycarbonate resin 8 is formed with a predetermined pattern. The polycarbonate resin 8 is taken out form the stamper 7. As shown in Fig. 1(g), a reflection layer or a recording layer 9 is formed on the surface formed with the predetermined pattern of the polycarbonate resin 8 by the sputtering method or like and a protective film 10 is further formed over the recording layer 9, and finally an optical disc is completed.

With respect to the photoresist, so-called novolac family resist, which is composed of cresol novolac resin as a base resin and naphthoquinone diazide as a photosensitive agent, is commonly utilized for a laser beam having a wavelength of 340 to 460 nm. In a case of a laser beam having a wavelength of 200 to 300 nm, so-called chemical amplification type resin, which is composed of a resin of hydroxyl group of polyhydroxy styrene protected by a protective group such as tert-butoxy carbonyl group as a base resin and photoacid generator such as sulfonium salt as a photosensitive agent, is commonly used.

A pattern shape of a pit or a groove of an optical disc is influenced by all processes related to forming a pit or a groove during a manufacturing process of the optical disc. However, an original shape of the pattern is a photoresist pattern obtained after the photoresist has been exposed and developed, so that a microscopic shape of the photoresist pattern is supposed to influence a signal performance of the optical disc.

There existed a jitter value of reproduced signal, which is one of indexes measuring performances of signal recorded in an optical disc. A jitter value exhibits a degree of scatter of reproduced signal. The smaller the jitter value is, the higher the quality of optical disc is. In other words, as far as an optical disc is small enough in jitter value, the optical disc has margins for inclination of disc, which happens when the optical disc is loaded in a drive and clamped on a spindle, and warp of disc caused by a change of temperature and humidity. Consequently, the optical disc can be reproduced stably. On the other hand, if a jitter value is essentially large, the jitter value will increase furthermore by a change of surroundings of the optical disc in use. Following this situation, a pit or reproduced signal can hardly be separated by a pickup. In some cases, a C1 error increases and, in a worst case, signal reproduction of the optical disc itself can not be performed any more.

According to the studies for affection of photoresist, it has been apparent that photoresist on the market such as naphthoquinone diazide - cresol novolac family photoresist, which has been commonly used until now, was large in jitter value and small in a margin for bit separation. Consequently, it has been pointed out that the photoresist was an obstacle to promoting higher packing density of optical disc. In other words, there existed a problem such that an optical disc having a high packing density of more than 20 GB, for example, can not be realized as far as the performance of photoresist is in the present condition.

### SUMMARY OF THE INVENTION

Accordingly, in consideration of the above-mentioned problem of the prior art, an object of the present invention is to provide positive photoresist for manufacturing an information recording medium in high quality, which can reduce a jitter value even in a higher packing density, a manufacturing method of an information recording medium by making use of the positive photoresist and the information recording medium manufactured by the manufacturing method.

In order to achieve the above mentioned object, the present invention provides, according to a first aspect thereof, a positive photoresist utilized for manufacturing an information recording medium, which is recorded with an information signal formed as a pit or groove on a disc, the positive photoresist is further characterized in that a modulus of compression elasticity of a solid component of the photoresist after removing a solvent component is set to be within a range of 8.0 × 10⁻³ to 5.0 × 10⁻¹ MPa at 100 °C.

According to a second aspect of the present invention, there provided a manufacturing method of an information recording medium by making use of the positive photoresist mentioned in the first aspect above, which comprises steps of: forming a positive photoresist film on a disc, wherein the positive photoresist is characterized in that a modulus of compression elasticity of a solid component of the photoresist after removing a solvent component is set to be within a range of 8.0 × 10⁻³ to 5.0 × 10⁻¹ MPa at 100 °C; forming a latent image on the positive photoresist film by irradiating a laser beam; forming one of a pit and a groove pattern by developing the latent image by an alkaline aqueous solution; producing a stamper by plating a metal on the pit or the groove pattern; and duplicating a plastic substrate formed with the pit or the groove pattern by using the stamper.

According to a third aspect of the present invention, there provided an information recording medium, which is manufactured by the manufacturing method mentioned in the second aspect of the present invention above.

Other object and further features of the present invention will be apparent from the following detailed description when read in conjunction with the accompanying drawings.

### BRIEF DESCRIPTION OF DRAWINGS

Figs. 1(a) through 1(g) are a process chart showing each step of a manufacturing process of an information recording medium in general.

Fig. 2 is an explanatory table showing a mixing ratio of cresol novolac resin and photosensitive agent, which is one example of an embodiment 1 of increasing a molecular weight of base resin of photoresist constituting a photoresist film according to the present invention.

Fig. 3 is an explanatory chart showing a weight-average molecular weight (Mw), a modulus of compression elasticity and a jitter value of an optical disc being manufacture by using the photoresist shown in Fig. 2.

Fig. 4 is a graph showing a relation between a modulus of compression elasticity and a jitter value of the photoresist shown in Fig. 3.

Fig. 5 is an explanatory chart showing a mixing ratio of a base resin and photoacid generator, which is another example of an embodiment 2 of increasing a molecular weight of base resin of photoresist constituting a photoresist film according to the present invention.

Fig. 6 is an explanatory chart showing a weight-average molecular weight (Mw), a modulus of compression elasticity and a jitter value of an optical disc being manufacture by using the photoresist shown in Fig. 5.

Fig. 7 is a graph showing a relation between a modulus of compression elasticity and a jitter value of the photoresist shown in Fig. 6.

Fig. 8 is an explanatory chart showing a adding ratio of photoresist and hardener available in the market, which is an embodiment 3 of adding hardener of a base resin to photoresist constituting a photoresist film according to the present invention.

Fig. 9 is an explanatory chart showing a weight-average molecular weight (Mw), a modulus of compression elasticity and a jitter value of an optical disc being manufacture by using the photoresist shown in Fig. 8.

Fig. 10 is a graph showing a relation between a modulus of compression elasticity and a jitter value of the photoresist shown in Fig. 9.

Fig. 11 is an explanatory chart showing a blending ratio of photoresist and light curable resin available in the market, which is a first example of an embodiment 4 of blending a curable resin with photoresist constituting a photoresist film according to the present invention.

Fig. 12 is an explanatory chart showing a blending ratio of photoresist and thermosetting resin available in the market, which is a second example of the embodiment 4 of blending a curable resin with photoresist constituting a photoresist film according to the present invention.

Fig. 13 is an explanatory chart showing a modulus of compression elasticity and a jitter value of an optical disc being manufacture by using the photoresist shown in Fig. 11.

Fig. 14 is an explanatory chart showing a modulus of compression elasticity and a jitter value of an optical disc being manufacture by using the photoresist shown in Fig. 12.

Fig. 15 is a graph showing a relation between a modulus of compression elasticity and a jitter value of the photoresist shown in Fig. 13.

Fig. 16 is a graph showing a relation between a modulus of compression elasticity and a jitter value of the photoresist shown in Fig. 14.

Fig. 17 is an explanatory chart showing a blending ratio of photoresist and light curable resin available in the market, which is a first example of an embodiment 5 of blending a curable resin with photoresist constituting a photoresist film according to the present invention.

Fig. 18 is an explanatory chart showing a blending ratio of photoresist and thermosetting resin available in the market, which is a second example of the embodiment 5 of blending a curable resin with photoresist constituting a photoresist film according to the present invention.

Fig. 19 is an explanatory chart showing a modulus of compression elasticity and a jitter value of an optical disc being manufacture by using the photoresist shown in Fig. 17.

Fig. 20 is an explanatory chart showing a modulus of compression elasticity and a jitter value of an optical disc being manufacture by using the photoresist shown in Fig. 18.

Fig. 21 is a graph showing a relation between a modulus of compression elasticity and a jitter value of the photoresist shown in Fig. 19.

Fig. 22 is a graph showing a relation between a modulus of compression elasticity and a jitter value of the photoresist shown in Fig. 20.

### DETAILED DESCRIPTION OF THE PREFERRED EMBODIMENTS

Prior to depicting each embodiment of the present invention, details common to each embodiment are explained first.

As a result of investigating the above-mentioned problem of the prior art, it becomes clear that deteriorating a jitter value is caused by deformation of a resist pattern while forming a conductive film or during a nickel plating process after a pit or a groove pattern is formed. In other words, either process of forming a conductive film or plating is a process of applying heat and stress to a resist film, so that the heat and stress deform a shape of pit or groove. Consequently, it becomes clear that the deformation of a shape of pit or groove causes a jitter value deteriorated.

The processes such as forming a conductive film and plating are regular processes. Therefore, it is supposed that such deformation of a shape of pit or groove has happened until now. However, deteriorating a jitter value caused by such the deformation has not emerged because a ratio of deformation amount with respect to a pit length and a track pitch is relatively small enough for an optical disc having a density of the order of 4.7 GB, for example. On the other hand, in a case of a higher density level such as more than 20 GB, as a pit length and a track pitch become shorter than those of 4.7 GB, a signal characteristic is deteriorated by the deformation even though a shape of pit or groove is slightly deformed.

As a result of studying for coping with higher density, it is found that by increasing a mechanical strength of photoresist, actually, by improving a modulus of compression elasticity, enhancing durability of photoresist for stress is effective for improving a signal characteristic.

A first method of increasing a mechanical strength of photoresist is increasing a molecular weight of base resin of the photoresist. In a case of the naphthoquinone diazide - cresol novolac family photoresist, which is generally utilized for a wavelength of 340 to 460 nm, the cresol novolac resin is used as a base resin. By increasing the weight-average molecular weight of the cresol novolac resin to more than 8000, photoresist having a desired mechanical strength can be obtained.

Further, recently, a light source for exposure is advanced to a shorter wavelength in order to cope with higher density. In a case of chemical amplification type resin being commonly utilized for a wavelength of 200 to 300 nm, by increasing the weight-average molecular weight of the polyhydroxy styrene resin, which is commonly used as a base resin, to more than 8000, photoresist having a desired mechanical strength can be obtained. On the contrary, increasing a molecular weight excessively will cause injurious effects upon the photoresist. One of such injurious effects is caused by growing a molecular size.

As a matter of fact, a size of signal to be recorded becomes smaller with advancing an optical disc to a higher density. In a case of recording a signal of over 20 GB, for example, its minimum pit length is required to be approximately 0.2 to 0.25 µm. Further, in a case that a molecular size of base resin constituting photoresist becomes larger, scattering of pit length caused by variation of development becomes wider and affects a jitter value. If a molecular weight of base resin becomes an order of some ten thousands, its molecular size becomes even some tens nm. The size can not be disregarded with respect to a pit length any more and becomes a level of deteriorating scattering of pit length.

Another injurious effect is decreasing of sensitivity. A dissolving speed into developer becomes slower as a molecular weight of base resin increases, so that an apparent sensitivity decreases. Although the decreasing of sensitivity is a problem of production efficiency, an exposure time being necessary for one glass substrate becomes longer in accordance with advancing an optical disc to a higher density, and accordingly decreasing sensitivity too much is not preferable for improving throughput. In consideration of these injurious effects, a weight-average molecular weight of base resin is desirable to be less than 20000.

A second method of increasing a mechanical strength of photoresist is making photoresist contain hardener for base resin.

As the cresol novolac resin as the base resin of the naphthoquinone diazide cresol novolac family photoresist also has a property of thermosetting resin, by adding an amine family hardener such as hexamethylene-tetramine into the cresol novolac resin and heating, the cresol novolac resin cross-links three-dimensionally and becomes a resin being never solved or melted. Accordingly, a firm photoresist film, which is never deformed while filming, can be obtained by adding hardener into currently available photoresist and applying heat so as to cross-link three-dimensionally after a pit or groove is formed through exposing and developing processes.

Although a heating temperature slightly varies by a type of hardener and a structure of the cresol novolac resin, generally, it is an order of 110 to 180 °C. In a case of less than 110 °C, curing reaction never happens. In a case of more than 180 °C, a contract amount becomes larger caused by curing reaction. Consequently, a pit size and a groove width or depth can hardly be controlled.

An amount of hardener is preferable to be within a range of 1 to 30 weight parts with respect to 100 weight parts of solid component in photoresist. In a case of less than 1 weight part, insufficient cross-linking density fails to obtain a desired strength. In a case of more than 30 weight parts, as hardener is generally soluble in water, a solubility amount or a film reducing amount of a section not exposed while developing becomes larger and surface roughness becomes coarse. Accordingly, a noise level of signal increases.

A third method of increasing a mechanical strength of photoresist is blending a resin such as a light curable resin and a thermosetting resin, which cross-links three-dimensionally and hardens by applying some treatment, with photoresist. This is a method of utilizing the conventional photoresist, which is blended with such a curable resin, as photoresist and increasing a total strength of a photoresist film by hardening only the blended component or the blended curable resin through irradiating the UV ray or heating after exposing and developing.

Since a resin to be blended itself has no function as positive photoresist, there existed a limitation for a blending ratio. The blending ratio is desirable to be within a range of 5 to 40 weight parts with respect to 100 weight parts of a solid component in photoresist. In a case of less than 5 weight parts, a desired strength of photoresist can be never obtained. In a case of more than 40 weight parts, it causes a defect such that resolution or sensitivity decreases as photoresist.

By using the various methods mentioned above, heat resistance is given to a photoresist film and strength of the photoresist film increases. Accordingly, the photoresist film is prevented from deformation while filming and plating, and an optical disc in high quality can be provided.

Actual embodiments of the present invention will be detailed next.

### [Embodiment 1]

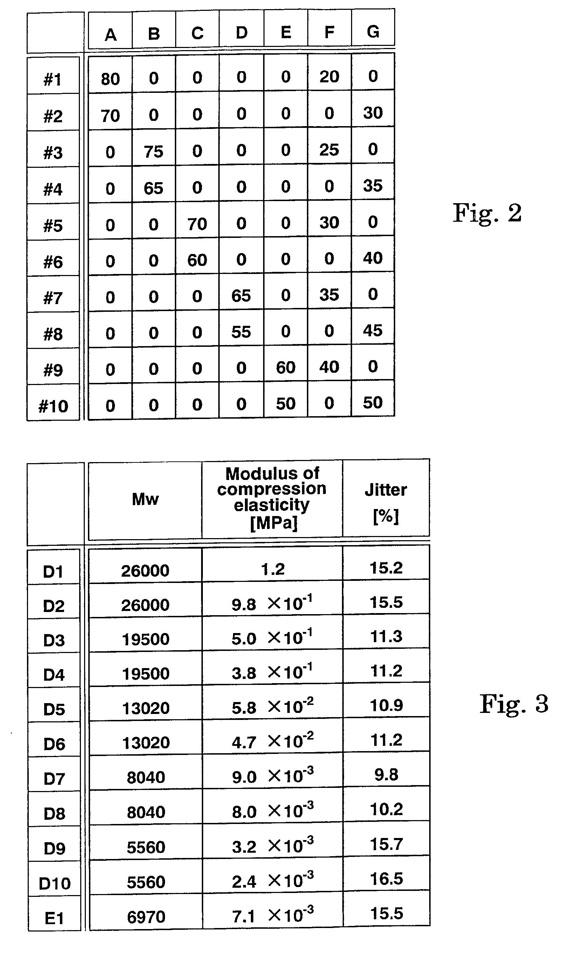

Fig. 2 is an explanatory table showing a mixing ratio of cresol novolac resin and photosensitive agent, which is one example of an embodiment 1 of increasing a molecular weight of base resin of photoresist constituting a photoresist film according to the present invention.

Fig. 3 is an explanatory chart showing a weight-average molecular weight (Mw), a modulus of compression elasticity and a jitter value of an optical disc being manufacture by using the photoresist shown in Fig. 2.

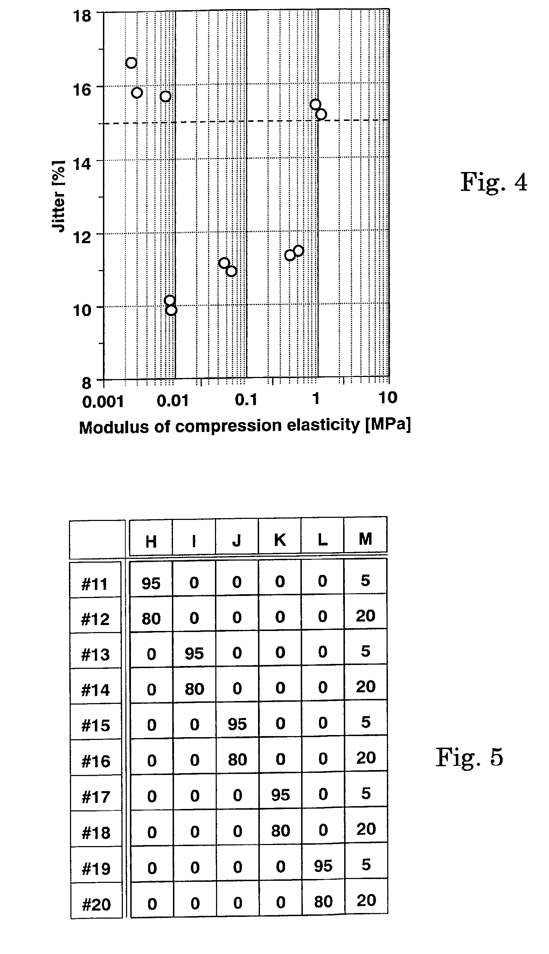

Fig. 4 is a graph showing a relation between a modulus of compression elasticity and a jitter value of the photoresist shown in Fig. 3.

Generally, positive photoresist utilized for a wavelength range of the order of 340 to 460 nm is composed of cresol novolac resin and benzophenone ester of modified naphthoquinone diazide as photosensitive agent, which are dissolved in a solvent together. By synthesizing the cresol novolac resin and the benzophenone ester respectively, positive photoresist composing the synthesized cresol novolac resin and benzophenone ester is compounded. Synthesizing each component is depicted next.

A synthesizing example of cresol novolac resin is as follows: pour distilled m-cresol and p-cresol in the proportion 1:1 into a separable flask having three mouths equipped with a circulating cooling tube and a thermometer, add 74 grams of a solution of 37 % formaldehyde and 2.3 grams of oxalic acid dihydrate into the flask, heat a total solution in the oil bath with agitating the total solution and react the total solution for a period of 15 hours at a reflux temperature.

Remove water from the total solution by reducing pressure in the flask to 30 mmHg, pour out the total solution into a metal vat and solidify after removing a solution not reacted yet by increasing a temperature inside the flask to 150 °C, and then approximately 100 grams of cresol novolac resin can be obtained. The cresol novolac resin obtained as mentioned above is divided into 5 fractions extending from a component in high molecular weight to a component in low molecular weight through the serial precipitation fraction method by using the ethyl cellosolve as a solvent and water as a precipitant. Consequently, 5 cresol novolac resins "A" through "E" are obtained. A weight-average molecular weight of each resin is measured by the gel permeation chromatography (GPC) method of standardizing polystyrene.

A first synthesizing example of photosensitive agent is as follows: fill 10 grams of 2-, 3-, 4- and 4'-tetrahydroxy benzophenone, 40 grams of 1- and 2-naphthoquinone diazide-5-sulfonyle chloride and 300 ml of γ-butyrolactone in a separable flask having three mouths and dissolve well. Drop a mixed solution of 20 grams of triethyl amine and 50 ml of acetone into the flask gradually and react with agitating the total solution for a period of 5 hours at room temperature. Drop the reacted total solution into an aqueous solution of hydrochloric acid, separate a deposit, wash the deposit by water and ethyl alcohol in order and dehydrate the deposit in a vacuum. Then a benzophenone ester "F" is obtained. 4-substitution product occupies 80 % of total dehydrated deposit when analyzing the deposit by a liquid chromatogram.

A second synthesizing example of photosensitive agent is as follows: fill 20 grams of 2-, 3- and 4-tetrahydroxy benzophenone, 50 grams of 1- and 2-naphthoquinone diazide-5-sulfonyle chloride and 250 ml of dioxane in a separable flask having three mouths and dissolve well. Drop 15 grams of triethyl amine into the flask gradually and react with agitating the total solution for a period of 4 hours at room temperature. Treat the total solution as the same process as the first example mentioned above. Then a benzophenone ester "G" is obtained. 3-substitution product occupies 80 % of total dehydrated deposit when analyzing the deposit as the same manner as the first synthesizing example.

Compounding photoresist is as follows: mix each of the cresol novolac resins "A" through "E" obtained as mentioned above, the benzophenone ester "F" obtained by the first synthesizing example of photosensitive agent and the benzophenone ester "G" obtained by the second synthesizing example of photosensitive agent in accordance with a ratio shown in Fig. 2 and dissolve the mixture in a solvent. Consequently, each of photoresist #1 through #10 is obtained by filtrating the dissolved mixture through a 0.2 µ m filter. Further, with respect to a solvent, 2-heptanone is used for a solvent and its consistency is compounded so as to enable to obtain a desired film thickness by the spin coat method.

By using the photoresist #1 through #10 compounded as mentioned above, respective optical discs are manufactured and a jitter characteristic of each disc is evaluated. With referring to Figs. 1(a) through 1(g) of the prior art, a manufacturing method of an optical disc is explained.

As shown in Fig. 1(a), the photoresist #1 (2) synthesized as mentioned above is coated on a surface of disc shaped glass substrate 1, which is polished finely and washed, by the spin coat method through an adhesive, and then the entire glass substrate 1 coated with the photoresist 2 is baked in an oven (not shown) for a period of 45 minutes at 80 °C so as to remove a solvent. A film thickness of the photoresist 2 is designated to be slightly thicker than 750 Å so as for an actual thickness of the photoresist 2 after development to be 750 Å.

As shown in Fig. 1(b), a Kr-laser beam 4 having a wavelength of 351 nm, which is modulated by a signal to be recorded, is condensed by a lens 3, irradiated on the surface of the photoresist 2 and exposes a predetermined area or a exposed area 5 of the photoresist 2 with allowing a predetermined period of time. A signal to be recorded is a group of pits of which a track pitch is 0.4 µm and a pit length is 3T to 11T if a minimum pit length 3T is 0.254 µm. A laser power is selected such that a jitter value becomes minimal in response to a sensitivity of the photoresist #1.

By developing the exposed area 5 with an aqueous solution of 0.2N potassium hydroxide for a period of 30 seconds, as shown in Fig. 1(c), the exposed area 5 is dissolved and a glass master having a roughened photoresist pattern 6 composed of a group of pits is obtained. As shown in Figs. 1(d) and 1(e), by using the glass master, a stamper 7 is manufactured by plating nickel over the glass master. As shown in Fig. 1(f), a polycarbonate resin 8 is injected into the stamper 7. As shown in Fig. 1(g), a reflection film 9 is formed on the surface of the polycarbonate resin 8 and further a protective film 10 is formed over the reflection film 9; and finally an optical disc D1 is obtained. The reflection film 9 is composed of aluminum having a film thickness of 700 Å.

As mentioned above, the optical disc D1 manufactured by using the photoresist #1 is explained. With respect to photoresist #2 through #10, an optical disc is manufactured by using each of the photoresist #2 through #10 as each of optical discs D2 through D10 respectively. In addition thereto, by using the conventional naphthoquinone diazide - cresol novolac family photoresist commonly available in the market, an optical disc E1 is manufactured as a comparative example through the same process as the optical disc D1.

An evaluation method of each optical disc is as follows: each optical disc manufactured as mentioned above is reproduced by using a laser pickup having a wavelength of 405 nm and a numerical aperture NA of 0.75. An reproduced output is analyzed by using a time interval analyzer and a jitter value is obtained from a signal distribution corresponding to each pit of a frequency characteristic curve. In other words, by sampling 105 signals with respect to only a signal of 3T, a frequency distribution per time is obtained and a jitter value is a standardized value, which is obtained by dividing a standard deviation of change of time base of the distribution by a period corresponding to 1T. In a case that a jitter value exceeds 15 %, pit separation margin while reproducing decreases and it becomes impractical. In a case of exceeding 17 %, a C1 error increases and it may be hard to reproduce continuously.

A measuring method of a modulus of compression elasticity exhibiting a mechanical strength of photoresist is explained next. Each of the photoresist #1 through #10 and the conventional photoresist S1 dissolved in a solvent (2-heptanone) is dropped into an aluminum pan having a diameter of 7 mm and a depth of 1.2 mm and dehydrated in a vacuum at 80 °C. In this case, consistency of photoresist can be determined arbitrarily and they shall be dehydrated in a low temperature and a low vacuum in order to prevent them from bubbling up. Repeating these operations of dropping and dehydrating several times fills the aluminum pan with the photoresist as much as the photoresist rises from the edge of aluminum pan. Finally, the surface of the photoresist is filed off so as to be flat and the surface height is arranged to be the same height as the aluminum pan after it is sufficiently dehydrated and a solvent is completely volatilized. Accordingly, samples for measurement are obtained.

The samples obtained as mentioned above are measured their moduli of compression elasticity at 100 °C by using the thermo mechanical analyzer, model TMA/SS10 manufactured by Seiko Instruments Inc. Applying a compression stress of 1.0 ± 0.5 g sinusoidally by a circular prove made by quartz having a contact area of 4.2 mm² while increasing an ambient temperature from a room temperature to approximately 150 °C to each sample obtains a modulus of compression elasticity at 100 °C by measuring a distortion amount at a moment.

As mentioned above, each of the optical disc D1 through D10 is manufactured. A result of evaluation is shown in Fig. 3. In Fig. 3, a weight-average molecular weight Mw of the base resin or the cresol novolac resin, a modulus of compression elasticity at 100 °C and a jitter value with respect to each sample of the photoresist #1 through #10 and S1 is listed. In Fig. 4, a relation between a modulus of compression elasticity at 100 °C of photoresist and a jitter value is exhibited. It exhibits the contents of Fig. 3 graphically. According to Fig. 4, a jitter value is less than 15 % within a range of 8.0 × 10⁻³ to 5.0 × 10⁻¹ MPa of modulus of compression elasticity of photoresist at 100 °C. As shown in Fig. 3, a molecular weight of the base resin at the minimum and maximum values is 8040 and 19500 respectively.

### [Embodiment 2]

Fig. 5 is an explanatory chart showing a mixing ratio of a base resin and photoacid generator, which is another example of an embodiment 2 of increasing a molecular weight of base resin of photoresist constituting a photoresist film according to the present invention.

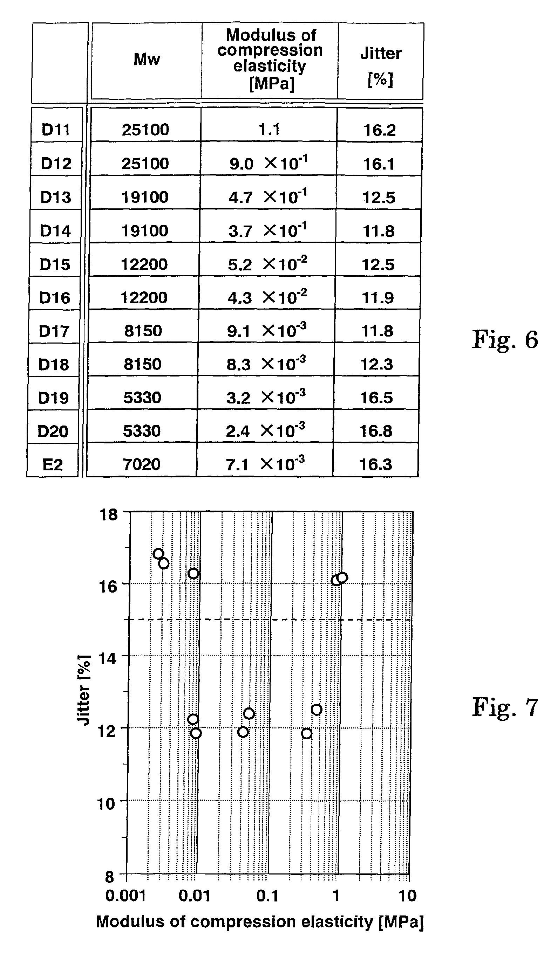

Fig. 6 is an explanatory chart showing a weight-average molecular weight (Mw), a modulus of compression elasticity and a jitter value of an optical disc being manufacture by using the photoresist shown in Fig. 5.

Fig. 7 is a graph showing a relation between a modulus of compression elasticity and a jitter value of the photoresist shown in Fig. 6.

Generally, chemical amplification type positive photoresist utilized for a wavelength range of the order of 200 to 300 nm is composed of a resin of hydroxyl group of polyhydroxy styrene protected by a protective group such as tert-butoxy carbonyl group as a base resin and an photoacid generator such as sulfonium salt as a photosensitive agent. Therefore, chemical amplification type positive photoresist containing these chemicals is manufactured.

A synthesizing example of a base resin is as follows: in a flask having four mouths displaced by nitrogen, dissolve 50 grams of polyhydroxy styrene resin (Trade name: Marukalinker-M manufactured by Maruzen Petrochemical Co., Ltd.) in 200 ml of acetone, add 17.63 grams of potassium carbonate, 8.48 grams of potassium iodide and 24.38 grams of tert-butyl bromo acetate into the solution and reflux for a period of 7 hours with agitating the total solution.

Further, distill out acetone after removing an insoluble component by filtering, and then dissolve in 150 ml of ethanol. The solution is dropped into 1500 ml of water and a polymer is deposited. The polymer is filtered out and dehydrated by wind for a period of 12 hours after being rinsed 5 times with 300 ml of water.

Furthermore, the dehydrated polymer is dissolved in 220 ml of ethanol once again and precipitated and refined through similar processes as mentioned above, and then an objective polymer of which weight is 52.0 grams is obtained after dehydrating for a period of 24 hours in a vacuum dryer at 50 °C. As a result of measurement of 1H-NMR spectrum, the objective polymer is found that 35 % of hydroxy group in the polyhydroxy styrene changes into the tert-butoxy carbonyl methyl ether.

The objective polymer or a base resin synthesized as mentioned above is divided into 5 fractions extending from a component in high molecular weight to a component in low molecular weight through the serial precipitation fraction method by using the ethyl cellosolve as a solvent and water as a precipitant. Consequently, 5 base resins "H" through "L" are obtained. A weight-average molecular weight of each resin is measured by the GPC (gel permeation chromatography) method of standardizing polystyrene.

Compounding photoresist is as follows: mix each of the base resins "H" through "L" obtained as mentioned above and triphenyl sulfonium trifrate "M" of photoacid generator in accordance with a ratio shown in Fig. 5 and dissolve the mixture in a solvent. Consequently, each of photoresist #11 through #20 is obtained by filtrating the dissolved mixture through a 0.2 µm filter. Further, with respect to a solvent, propylene glycol monomethyl ether acetate is used for a solvent and its consistency is compounded so as to enable to obtain a desired film thickness by the spin coat method.

By using the photoresist #11 through #20 compounded as mentioned above, respective optical discs D11 through D20 are manufactured and a jitter characteristic of each disc is evaluated. Manufacturing processes of an optical disc is identical to those of the embodiment 1, so that only a manufacturing method being different from that of the embodiment 1 is explained next.

The photoresist #11 is coated on a quartz glass substrate by using the same method as the embodiment 1.

A YAG quadruple wave laser beam having a wavelength of 266 nm, which is modulated by a signal to be recorded, is condensed by a lens, irradiated on the surface of the photoresist #11 and exposes a predetermined area or an exposed area of the photoresist #11 with allowing a predetermined period of time. A signal to be recorded is a group of pits of which a track pitch is 0.34 µm and a pit length is 3T to 11T if a minimum pit length 3T is 0.19 µm. A laser power is selected such that a jitter value becomes minimal in response to a sensitivity of the photoresist #11.

By developing the exposed area of the photoresist #11 with an aqueous solution of 2.38 % tetramethyl ammonium hydrido for a period of 30 seconds after baking process by a hot plate for a period of 90 seconds at 110 °C, the exposed area is dissolved and a glass master having a roughened photoresist pattern composed of a group of pits is obtained. These processes from exposing to developing are performed in atmosphere of ammonium of which consistency is controlled to be less than 5 ppb.

By using the glass master, a stamper is manufactured through the same process as the embodiment 1 and finally the optical disc D11 is obtained.

As mentioned above, the optical disc D11 manufactured by using the photoresist #11 is explained. With respect to photoresist #12 through #20, an optical disc is manufactured by using each of the photoresist #12 through #20 as each of optical discs D12 through D20 respectively. In addition thereto, by using the conventional chemical amplification type photoresist S2 commonly available in the market, an optical disc E2 is manufactured as a comparative example through the same process as the optical disc D11.

The optical discs D11 through D20 and E2 manufactured as mentioned above are evaluated by the same method as the embodiment 1. A result of the evaluation is shown in Fig. 6, and further its resultant is graphed in Fig. 7. In Fig. 7, a relation between a modulus of compression elasticity at 100 °C of photoresist and a jitter value is exhibited. According to Fig. 7, a jitter value is less than 15 % within a range of 8.0 × 10⁻³ to 5.0 × 10⁻¹ MPa of modulus of compression elasticity of photoresist at 100 °C. Further, a molecular weight of the base resin at the minimum and maximum values is 8150 and 19100 respectively.

### [Embodiment 3]

By adding a hardener for base resin into photoresist, an embodiment of a method for increasing strength of a photoresist film is explained.

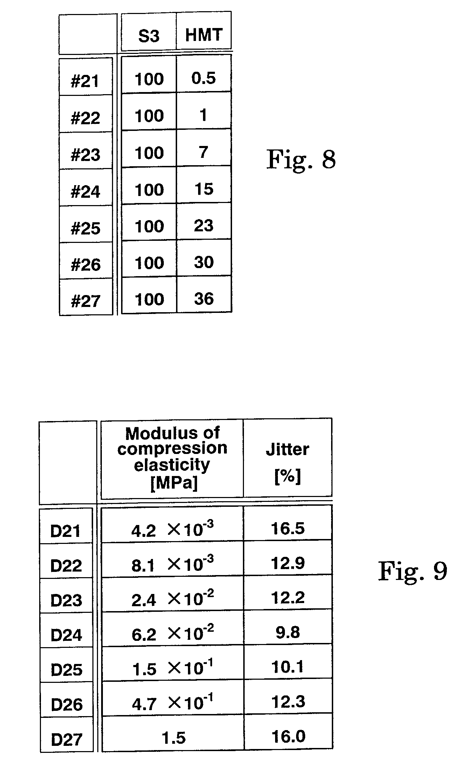

Fig. 8 is an explanatory chart showing a adding ratio of photoresist and hardener available in the market, which is an embodiment 3 of adding hardener of a base resin to photoresist constituting a photoresist film according to the present invention.

Fig. 9 is an explanatory chart showing a weight-average molecular weight (Mw), a modulus of compression elasticity and a jitter value of an optical disc being manufacture by using the photoresist shown in Fig. 8.

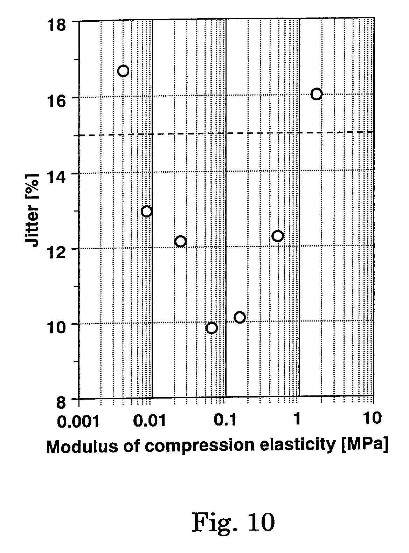

Fig. 10 is a graph showing a relation between a modulus of compression elasticity and a jitter value of the photoresist shown in Fig. 9.

Compounding photoresist is as follows: add hexamethylentetramine (referred to as "HMT" in Fig. 8) to the naphthoquinone diazide - cresol novolac family photoresist on the market (Trade name: THMR-iP3100 manufactured by Tokyo Ohka Kogyo Co. Ltd., referred to as "S3" in Fig. 8) in accordance with a ratio shown in Fig. 8 and dilute the mixture in a solvent. Consequently, each of photoresist #21 through #27 is obtained by filtrating the diluted mixture through a 0.2 µ m filter. Further, with respect to a solvent, a blended solvent containing 90 % of ester lactate and 10 % of butyl acetate is used for a solvent and its consistency is compounded so as to enable to obtain a desired film thickness by the spin coat method. Further, an additive amount shown in Fig. 8 is exhibited as a ratio of a component weight to a weight of resin solid component in photoresist, which is defined to be 100 weight parts.

By using the photoresist #21 through #27 compounded as mentioned above, respective optical discs D21 through D27 are manufactured and a jitter characteristic of each disc is evaluated. Manufacturing processes of each optical disc is identical to those of the embodiment 1, so that only a manufacturing method being different from that of the embodiment 1 is explained next.

The photoresist #21 is coated on a green glass substrate by the same method as the embodiment 1.

A Kr-laser beam having a wavelength of 351 nm, which is modulated by a signal to be recorded, is condensed by a lens, and irradiated on the surface of the photoresist #21 and exposes a predetermined area or a exposed area of the photoresist #21 with allowing a predetermined period of time. A signal to be recorded is a group of pits of which a track pitch is 0.4 µm and a pit length is 3T to 11T if a minimum pit length 3T is 0.254 µm. A laser power is selected such that a jitter value becomes minimal in response to a sensitivity of the photoresist #21.

By baking the exposed green glass substrate coated with the photoresist #21 for a period of 5 minutes at 150 °C in an oven after developing the exposed area of the photoresist #21 with an aqueous solution of 2.38 % tetramethyl ammonium hydrido for a period of 30 seconds, a glass master having a roughened photoresist pattern composed of a group of pits is obtained. A stamper and an optical disc D21 is obtained from the glass master by using the same method as the embodiment 1.

As mentioned above, the optical disc D21 manufactured by using the photoresist #21 is explained. With respect to photoresist #22 through #27, an optical disc is manufactured by using each of the photoresist #22 through #27 as each of optical discs D22 through D27.

The optical discs D21 through D27 manufactured as mentioned above are evaluated by the same method as the embodiment 1. A result of the evaluation is shown in Fig. 9, and further its resultant is graphed in Fig. 10. In Fig. 10, a relation between a modulus of compression elasticity at 100 °C of photoresist and a jitter value is exhibited. According to Fig. 10, it is confirmed that a jitter value is less than 15 % within a range of 8.0 × 10⁻³ to 5.0 × 10⁻¹ MPa of modulus of compression elasticity of photoresist at 100 °C.

### [Embodiment 4]

By blending a curable resin into photoresist, an embodiment of method for increasing strength of a photoresist film is explained.

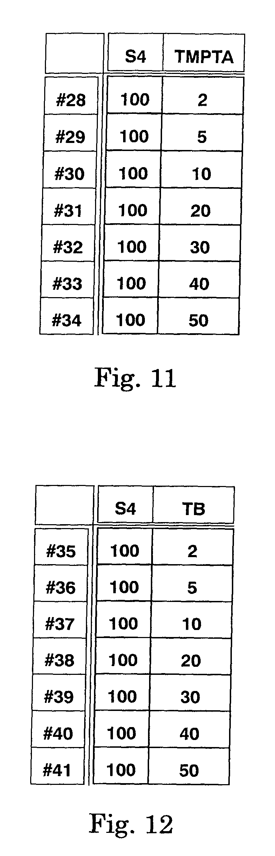

Fig. 11 is an explanatory chart showing a blending ratio of photoresist and light curable resin available in the market, which is a first example of an embodiment 4 of blending a curable resin with photoresist constituting a photoresist film according to the present invention.

Fig. 12 is an explanatory chart showing a blending ratio of photoresist and thermosetting resin available in the market, which is a second example of an embodiment 4 of blending a curable resin with photoresist constituting a photoresist film according to the present invention.

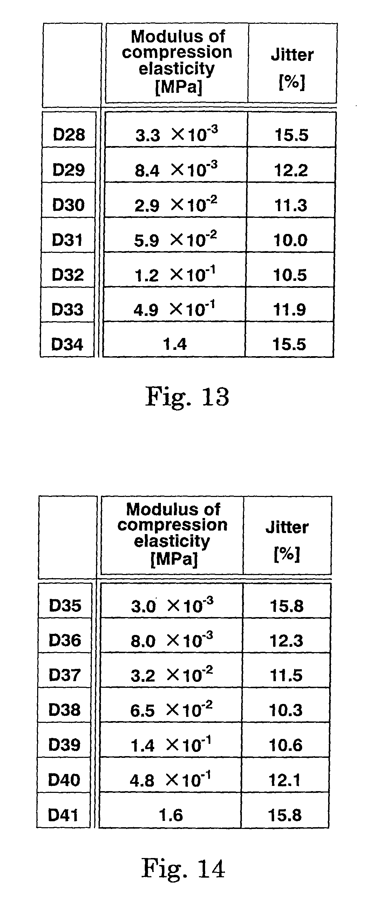

Fig. 13 is an explanatory chart showing a modulus of compression elasticity and a jitter value of an optical disc being manufacture by using the photoresist shown in Fig. 11.

Fig. 14 is an explanatory chart showing a modulus of compression elasticity and a jitter value of an optical disc being manufacture by using the photoresist shown in Fig. 12.

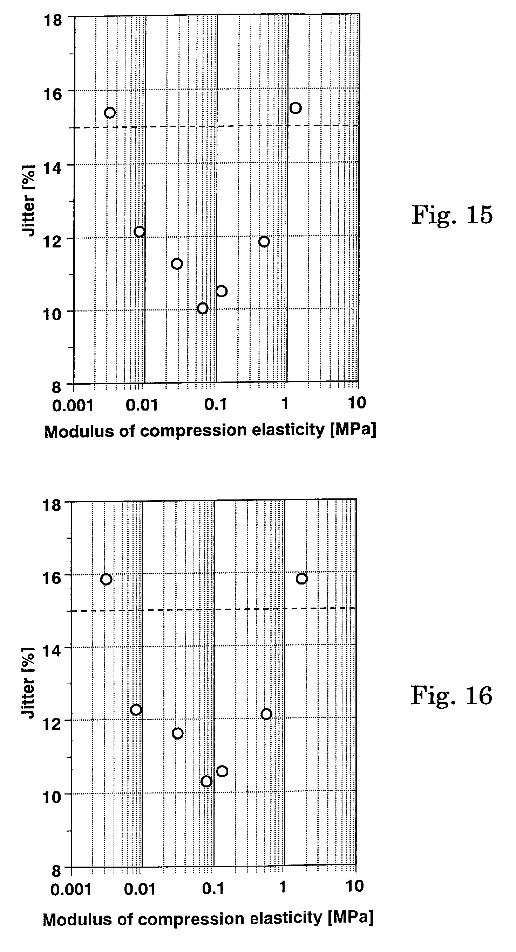

Fig. 15 is a graph showing a relation between a modulus of compression elasticity and a jitter value of the photoresist shown in Fig. 13.

Fig. 16 is a graph showing a relation between a modulus of compression elasticity and a jitter value of the photoresist shown in Fig. 14.

Compounding photoresist is as follows: blend trimethylol propane triaclylete (containing 10 % of photo initiator, referred to as "TMPTA" in Fig. 11) as a light curable resin and TB-3042 (manufactured by Three Bond Co., Ltd., referred to as "TB" in Fig. 12) as a thermosetting resin with the naphthoquinone diazide - cresol novolac family photoresist on the market (trade name: THMR-AR80 manufactured by Tokyo Ohka Kogyo Co., Ltd., referred to as "S4" in Fig. 11) in accordance with a ratio shown in Figs. 11 and 12, and dilute the mixture in a solvent. Consequently, each of photoresist #28 through #41 is obtained by filtrating the diluted mixture through a 0.2 µm filter. Further, with respect to a solvent, a blended solvent containing 90 % of ester lactate and 10 % of butyl acetate is used for a solvent and its consistency is compounded so as to enable to obtain a desired film thickness by the spin coat method. Further, an additive amount shown in Figs. 11 and 12 is exhibited as a ratio of a component weight to a weight of resin solid component in photoresist, which is defined to be 100 weight parts.

By using the photoresist #28 through #41 compounded as mentioned above, respective optical discs D28 through D41 are manufactured and a jitter characteristic of each disc is evaluated. Manufacturing processes of the optical discs are identical to those of the embodiment 1, so that only a manufacturing method being different from that of the embodiment 1 is explained next.

The photoresist is coated on a green glass substrate by the same method as the embodiment 1.

A Kr-laser beam having a wavelength of 351 nm, which is modulated by a signal to be recorded, is condensed by a lens, and irradiated on the surface of the photoresist and exposes a predetermined area or a exposed area of the photoresist with allowing a predetermined period of time. A signal to be recorded is a group of pits of which a track pitch is 0.4 µm and a pit length is 3T to 11T if a minimum pit length 3T is 0.254 µm. A laser power is selected such that a jitter value becomes minimal in response to a sensitivity of the photoresist.

By irradiating a ultraviolet light on the photoresist blended with the light curable resin "TMPTA", or by baking the exposed green glass substrate coated with the photoresist blended with the thermosetting resin "TB" for a period of 5 minutes at 150 °C in an oven after developing the exposed area of the photoresist with an aqueous solution of 2.38 % tetramethyl ammonium hydrido for a period of 30 seconds, a glass master having a roughened photoresist pattern composed of a group of pits is obtained.

A stamper and an optical disc are obtained from the glass master by using the same method as the embodiment 1.

As mentioned above, the optical disc D28 manufactured by using the photoresist #28 is explained. With respect to photoresist #29 through #41, each of the optical discs D29 through D41 is manufactured by using each of the photoresist #29 through #41 respectively by the same processes as the optical disc D28.

Each of the optical discs D28 through D41 manufactured as mentioned above is evaluated by the same method as the embodiment 1. A result of the evaluation is shown in Figs. 13 and 14, and further its resultant is graphed in Figs. 15 and 16 respectively. In Figs. 15 and 16, a relation between a modulus of compression elasticity at 100 °C of photoresist and a jitter value is exhibited. According to Figs. 15 and 16, it is confirmed that a jitter value is less than 15 % within a range of 8.0 x 10⁻³ to 5.0 × 10⁻¹ MPa of modulus of compression elasticity of photoresist at 100 °C.

### [Embodiment 5]

By blending a curable resin into photoresist on the market, an embodiment of method for increasing strength of a photoresist film is explained.

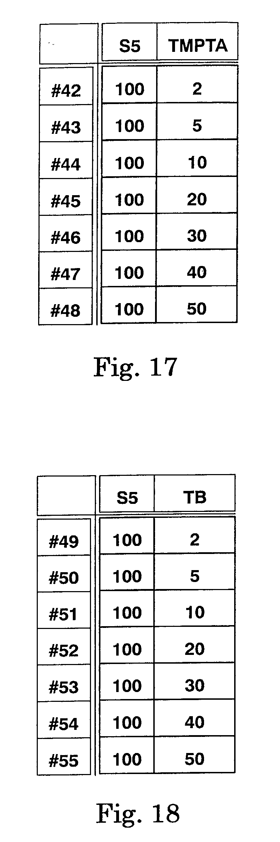

Fig. 17 is an explanatory chart showing a blending ratio of photoresist and light curable resin available in the market, which is a first example of an embodiment 5 of blending a curable resin with photoresist constituting a photoresist film according to the present invention.

Fig. 18 is an explanatory chart showing a blending ratio of photoresist and thermosetting resin available in the market, which is a second example of the embodiment 5 of blending a curable resin with photoresist constituting a photoresist film according to the present invention.

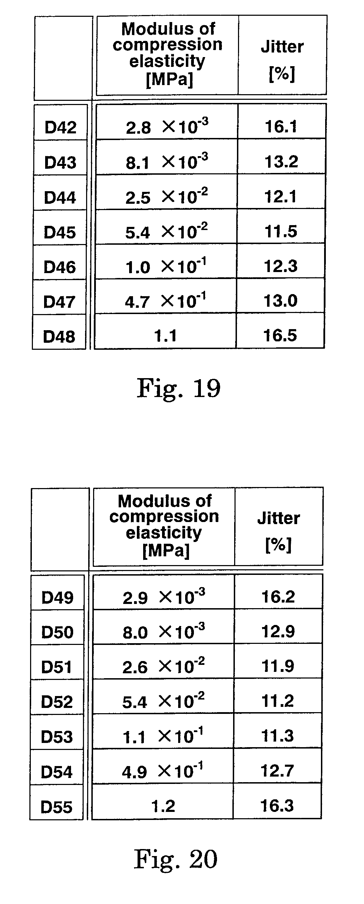

Fig. 19 is an explanatory chart showing a modulus of compression elasticity and a jitter value of an optical disc being manufacture by using the photoresist shown in Fig. 17.

Fig. 20 is an explanatory chart showing a modulus of compression elasticity and a jitter value of an optical disc being manufacture by using the photoresist shown in Fig. 18.

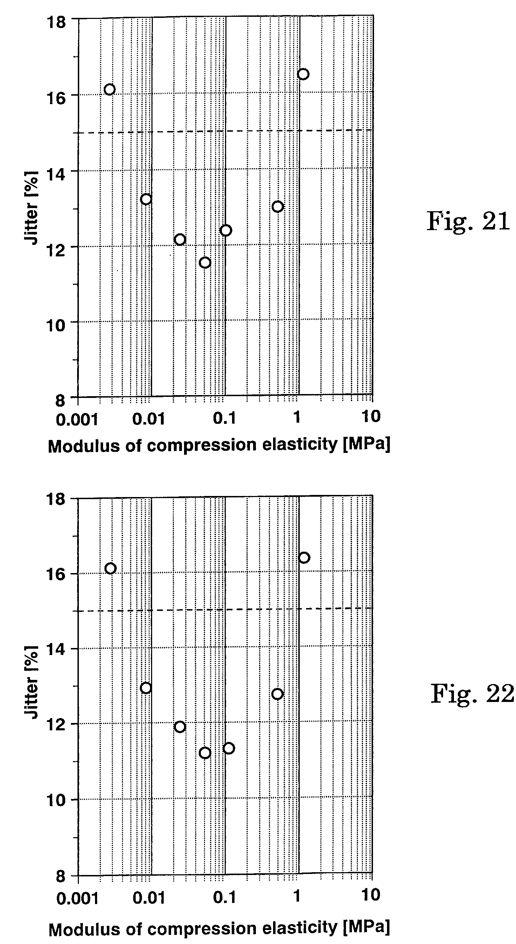

Fig. 21 is a graph showing a relation between a modulus of compression elasticity and a jitter value of the photoresist shown in Fig. 19.

Fig. 22 is a graph showing a relation between a modulus of compression elasticity and a jitter value of the photoresist shown in Fig. 20.

Compounding photoresist is as follows: blend trimethylol propane triaclylete (containing 10 % of photo initiator, referred to as "TMPTA" in Fig. 17) as a light curable resin and TB-3042 (manufactured by Three Bond Co., Ltd., referred to as "TB" in Fig. 18) as a thermosetting resin with the chemical amplification type photoresist on the market (trade name: TDUR-P308 manufactured by Tokyo Ohka Kogyo Co., Ltd., referred to as "S5" in Figs. 17 and 18) in accordance with a ratio shown in Figs. 17 and 18, and dilute the mixture in a solvent. Consequently, each of photoresist #42 through #55 is obtained by filtrating the diluted mixture through a 0.2 µ m filter. Further, with respect to a solvent, propylene glycol monomethyl ether acetate is used for a solvent and its consistency is compounded so as to enable to obtain a desired film thickness by the spin coat method. Further, a blending amount shown in Figs. 17 and 18 is exhibited as a ratio of a component weight to a weight of resin solid component in photoresist, which is defined to be 100 weight parts.

By using the photoresist #42 through #55 compounded as mentioned above, respective optical discs D42 through D55 are manufactured by using the same method as the embodiment 2. Each optical disc is formed with a group of pits of which a track pitch is 0.34 µm and a pit length is 3T to 11T, wherein a minimum pit length 3T is 0.19 µm. By irradiating a ultraviolet light on the photoresist blended with the light curable resin "TMPTA", or by baking the exposed green glass substrate coated with the photoresist blended with the thermosetting resin "TB" for a period of 5 minutes at 150 °C in an oven after development, a glass master having a roughened photoresist pattern composed of a group of pits is obtained. A stamper and each of the optical discs D42 through D55 are obtained from the glass master by using the same method as the embodiment 1.

The optical discs D42 through D55 manufactured as mentioned above are evaluated by the same method as the embodiment 1. A result of the evaluation is shown in Figs. 19 and 20, and further its resultant is graphed in Figs. 21 and 22. According to Figs. 20 and 21, it is confirmed that a jitter value is less than 15 % within a range of 8.0 × 10⁻³ to 5.0 × 10⁻¹ MPa of modulus of compression elasticity of photoresist at 100 °C.

While the invention has been described above with reference to specific embodiments thereof, it is apparent that many changes, modifications and variations in the arrangement of equipment and devices and in materials can be made without departing from the invention concept disclosed herein. Further, an effect of the present invention is remarkable on not only an optical disc having a roughened pit pattern explained in the embodiments but also any other medium of a different recording method.

For example, uniformity of groove width is one of the most important factors affecting quality of a reproduced signal characteristic even in a rewritable information recording medium having a continuous groove. Increasing a mechanical strength of photoresist can control scattering of groove width. Therefore, the manufacturing method of information recording medium according to the present invention can be applied to a rewritable information recording medium having a continuous groove.

Further, in the embodiments, a wavelength of a laser beam for exposure is exemplified by 351 nm and 266 nm. However, a wavelength is not limited to them. Furthermore, several methods are exemplified as a method of increasing a mechanical strength of photoresist. Nevertheless, a method of increasing a mechanical strength of photoresist is not limited to the methods mentioned in the embodiments.

According to an aspect of the present invention, there provided a positive photoresist utilized for manufacturing an information recording medium, which is recorded with an information signal formed as a pit or a groove on a disc. A modulus of compression elasticity of a solid component of the photoresist after removing a solvent component is set to be within a range of 8.0 × 10⁻³ to 5.0 × 10⁻¹ MPa at 100 °C, so that deformation of a pit or a groove can be reduced in a succeeding process. Accordingly, a high density information recording medium in high quality such as small in jitter value can be provided.

According to another aspect of the present invention, there provided a manufacturing method of an information recording medium by making use of the above-mentioned positive photoresist. The manufacturing method comprises a a step of forming a film of positive photoresist mentioned above, a step of forming a latent image by irradiating a laser beam on the photoresist film, a step of forming a pit or a groove pattern by developing the latent image by an alkaline aqueous solution, a step of producing a stamper by plating a metal on the pit or the groove pattern and a step of duplicating a plastic substrate formed with the pit or the groove pattern by using the stamper. By this manufacturing method, a mechanical strength of photoresist can be improved, so that deformation of a pit or a groove can be reduced in a succeeding process. Accordingly, a high density information recording medium in high quality such as small in jitter value can be provided.

According to a further aspect of the present invention, there provided an information recording medium manufactured by the above-mentioned manufacturing method, which is in high density and in higher quality being small in jitter value.

## Claims

1. A positive photoresist utilized for manufacturing an information recording medium, which is recorded with an information signal formed as a pit or groove on a disc, the positive photoresist is further **characterized in that** a modulus of compression elasticity of a solid component of the photoresist after removing a solvent component is set to be within a range of 8.0 × 10⁻³ to 5.0 × 10⁻¹ MPa at 100 °C.

2. A manufacturing method of an information recording medium comprising steps of:
forming a positive photoresist film on a disc, wherein the positive photoresist is **characterized in that** a modulus of compression elasticity of a solid component of the photoresist after removing a solvent component is set to be within a range of 8.0 × 10⁻³ to 5.0 × 10⁻¹ MPa at 100 °C;
forming a latent image on the positive photoresist film by irradiating a laser beam;
forming one of a pit and a groove pattern by developing the latent image by an alkaline aqueous solution;
producing a stamper by plating a metal on the pit or the groove pattern; and
duplicating a plastic substrate formed with the pit or the groove pattern by using the stamper.

3. An information recording medium manufactured by a manufacturing method comprising steps of:
forming a positive photoresist film on a disc, wherein the positive photoresist is **characterized in that** a modulus of compression elasticity of a solid component of the photoresist after removing a solvent component is set to be within a range of 8.0 × 10⁻³ to 5.0 × 10⁻¹ MPa at 100 °C;
forming a latent image on the positive photoresist film by irradiating a laser beam;
forming one of a pit and a groove pattern by developing the latent image by an alkaline aqueous solution;
producing a stamper by plating a metal on the pit or the groove pattern; and
duplicating a plastic substrate formed with the pit or the groove pattern by using the stamper.
